# EUROPEAN PATENT SPECIFICATION

(11) **EP 4 231 367 B1**
(45) Date of publication and mention of the grant of the patent: **31.12.2025**
(21) Application number: 22157162.3
(22) Date of filing: 17.02.2022
(51) Int. Cl.: H10K 30/10, H10K 30/87, H10K 85/00, H10K 30/50, H10K 30/81

(54) **ELECTRODE ASSEMBLY, PROCESS FOR MANUFACTURING AN ELECTRODE ASSEMBLY, PHOTOVOLTAIC DEVICE, AND USE OF A NON-CLOSE PACKED MONOLAYER OF TRANSPARENT PARTICLES IN AN ELECTRODE ASSEMBLY**
ELEKTRODENANORDNUNG, VERFAHREN ZUR HERSTELLUNG EINER ELEKTRODENANORDNUNG, PHOTOVOLTAISCHE VORRICHTUNG UND VERWENDUNG EINER NICHT DICHT GEPACKTEN MONOSCHICHT AUS DURCHSICHTIGEN TEILCHEN IN EINER ELEKTRODENANORDNUNG
ENSEMBLE ÉLECTRODE, PROCÉDÉ DE FABRICATION D'UN ENSEMBLE ÉLECTRODE, DISPOSITIF PHOTOVOLTAÏQUE ET UTILISATION D'UNE MONOCOUCHE COMPRIMÉE NON FERMÉE DE PARTICULES TRANSPARENTES DANS UN ENSEMBLE ÉLECTRODE

(43) Date of publication of application: 23.08.2023
(73) Proprietor: Friedrich-Alexander-Universität Erlangen-Nürnberg, in Vertretung des Freistaates Bayern, 91058 Erlangen (DE)
(72) Inventor: MÍNGUEZ BACHO, Ignacio, 91058 Erlangen (DE); BACHMANN, Julien, 91058 Erlangen (DE); VOGEL, Nicolas, 91058 Erlangen (DE); BÜTTNER, Pascal, 91058 Erlangen (DE); SCHELER, Florian, 91058 Erlangen (DE)
(74) Representative: Aera A/S

(56) References cited:
- CN-A- 105 469 996
- CN-A- 113 161 493
- ENRICHI F ET AL: "Plasmonic enhanced solar cells: Summary of possible strategies and recent results", RENEWABLE AND SUSTAINABLE ENERGY REVIEWS, vol. 82, 6 September 2017 (2017-09-06), pages 2433 - 2439, XP085314694, ISSN: 1364-0321, DOI: 10.1016/J.RSER.2017.08.094
- TANG JO SING JULIA ET AL: "Surface Patterning with SiO 2 @PNiPAm Core-Shell Particles", vol. 3, no. 9, 27 September 2018 (2018-09-27), US, pages 12089 - 12098, XP055944105, ISSN: 2470-1343, Retrieved from the Internet <URL:http://pubs.acs.org/doi/pdf/10.1021/acsomega.8b01985> DOI: 10.1021/acsomega.8b01985

## Description

The present invention is directed to an electrode assembly, a process for manufacturing an electrode assembly, a photovoltaic device, and the use of a non-close packed monolayer of transparent particles in an electrode assembly.

Photovoltaic technologies aim at getting as much energy from photovoltaic devices, like, for example, solar panels, as possible. Ideally, solar panels would be working at their peak performance during the sunlight hours. Usually, solar panels are placed at a fixed angle, where they get the most direct sunlight, i.e., ideally at an incident angle orthogonal to the solar panel surface, at a specific location. However, the elevation angle of the sun is continuously changing depending on the time of day and the season, which results in a continuously varying incident angle of light falling onto the solar panels as well as the light intensity. Therefore, one of the main aspects to consider is the direction the solar panel should be aimed at. A practical solution already implemented comprises automated solar panels that are moved along tracks that follow the course of the sun, so that they are always operating at their optimum orientation. However, this approach consumes energy, is expensive to implement and the corresponding mechanics are heavy and bulky to be installed on rooftops. Thus, its use is in general limited to photovoltaic farms.

Therefore, it is an object of the present invention to provide an electrode assembly to be used, for example, in photovoltaic devices, which allows to harvest most efficiently photons independently on the incident angle and light intensity conditions, even, for example, when the photovoltaic device is placed at a fixed angle on a roof or a window, or it is used for in-door applications.

The object of the present invention is solved by providing an electrode assembly according to claim 1.

The object of the present invention is further solved by providing a process for manufacturing an electrode assembly, according to claim 4.

The object of the present invention is further solved by providing a photovoltaic device, preferably a thin-film photovoltaic device, according to claim 11.

The object of the present invention is further solved by providing the use of a non-close packed monolayer of transparent particles in an electrode assembly, according to claim 12.

Typically, in the prior art, monolayers of silica spheres, which are self-assembled forming close-packed structures, have been used in solar cells as antireflective coatings or light trapping structures. However, until now these structures are used as additional layers of the devices only. Documents CN113161493 (A) and CN105469996 (A) disclose an electrode assembly comprising particles.

In contrast to the prior art, the present invention is based on the concept to provide a novel electrode assembly according to the claims having a photonic nano-structured heterojunction, which affects the opto-electronic properties of the system such that the electrode assembly is able to harvest solar energy more efficiently independently of the light intensity and incident angle conditions compared to the planar devices known from the prior art. The topography/profile of the heterojunction is built by means of particles, which are at a distance to each other in a non-close packed array, i.e. the particles are not in contact with each other, there are gaps between every two adjacent particles. The light paths in the light absorber are enlarged with respect to a planar configuration, hence the electrode assembly, when implemented in a solar cell, is able to absorb light more efficiently and therefore to produce more photogenerated charges. Unlike close-packed monolayers as present in the prior art, non-close packed arrays are beneficial for a better light-matter interaction, because the interface area is enlarged and the sunlight reaches the photonic structures at a broader range of incident angles.

The particles can be arranged either in a hexagonal pattern or can be spread randomly over the surface of the electrode. At least the electrode on the light-facing side is made of a transparent material so that it allows for the light to go through it and to reach the light absorber. The rear electrode can be made either of a transparent material or metal. The non-close packed array side of the electrode assembly could be either the light-facing side or the rear side.

The present electrode assemblies can be applied straightforwardly to thin film photovoltaic technologies already commercially available, multi-junction cells, and especially to those considered as emerging photovoltaics in prototyping phase or pilot line phase with disruptive potential such as perovskites or quantum dot solar cells. Additionally, the present electrode assemblies can be applied to the fabrication of multi-junction and tandem solar cells technologies. Depending on the type of technology where the electrode assembly is applied, the final application can go from the conventional use of c-Si panels to building integrated photovoltaics or low light intensity applications (e.g. wearables or small electronic appliances).

These electrode assemblies implemented in solar cells are not only improved via light management, but also form vivid, iridescent colors, which add an aesthetical aspect to the devices. Transparency and photonic structured electrode assemblies combined with the fact that thin film photovoltaics are light-weighted make applications also in wearables very promising.

Additionally, the electrode assemblies according to the present invention combine the geometries of the non-close packed arrays and the thickness of the light absorber to optimize light harvesting as well as charge generation and extraction.

### Figures

- Fig. 1: shows a top view scanning electron microscopy micrograph of the core/shell monolayer according to the present invention on a tin-doped indium oxide (ITO) substrate;
- Fig. 2(a)-2(d): show a general layer arrangement and three possible layer structures for the electrode assembly of the present invention;
- Fig. 3(a): shows a graph of the photocurrent density (J), in the Y axes, versus voltage (V), in the X axes, of two solar cell devices, one being according to the invention, the other one being a comparative example, having the same heterojunction materials and thicknesses under light illumination at 100 mW cm⁻²;

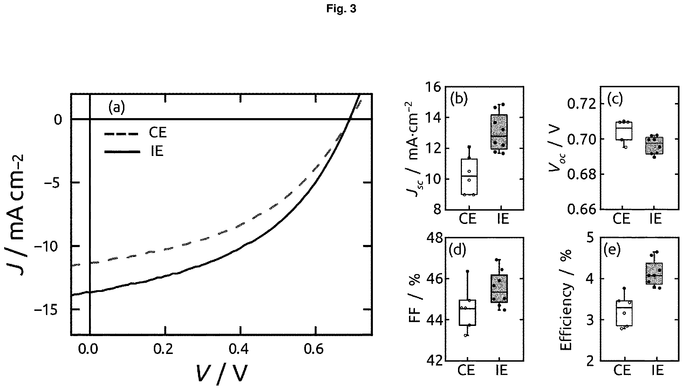

- Fig. 3(b,c,d,e): displays box plot graphs including short circuit current, open circuit voltage, fill factor and efficiencies obtained from a number of devices fabricated out of the same original sample;

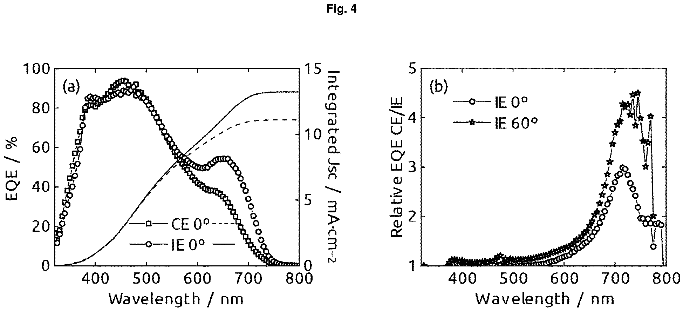

- Fig. 4(a): shows the EQE (left Y axis) and the corresponding integrated Jsc (right Y axis) in function of the incident wavelength (x axis);
- Fig. 4(b): shows the ratio of EQE spectra between IE and CE samples (Y axis) in function of the incident wavelength (x axis).

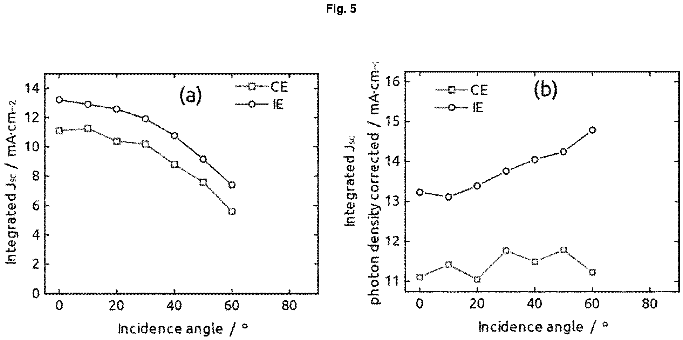

- Fig. 5(a): displays the short circuit current Jsc (Y axis), calculated by integrating the measured EQE spectra, versus the incidence angle of light (X axis);
- Fig. 5(b): displays the short-circuit current taking into account the diminishing effective photon density incident onto the electrode as a result of the tilting (Y axis) versus the incidence angel of light (X axis).

A first aspect of the present invention relates to an electrode assembly comprising, preferably consisting of,
(a) a first electrode (1),
(b) a monolayer of particles (2),
(c) an electron transport material (ETM) layer (3) having a thickness between 10 and 200 nm,
(d) a light-absorbing layer (4) having a thickness of 2 µm or less,
(e) a hole transport material (HTM) layer (5) having a thickness between 10 and 200 nm, and
(f) a second electrode (6),

wherein at least one of the first and the second electrode (1, 6) is transparent;
wherein said monolayer of particles (2) is a non-close packed monolayer;
wherein the monolayer of particles (2) is obtained by depositing a non-close packed monolayer of core-shell particles and subsequently removing the shell from said as-deposited non-close packed monolayer of core-shell particles such that the resulting particles (2) are not in contact with each other; and
wherein a minimum interparticle distance in the monolayer of particles (2) is equal to or greater than two times the thickness of the shell of said core-shell particles, and
wherein the particles (2) comprised in said monolayer (b) have an average particle size in a range of from 100 nm to 2 µm, preferably from 100 nm to 1 µm and more preferably from 200 nm to 800 nm.

A conductive material is used as the first electrode (1) and the second electrode (6). Each of the electrodes (1,6) is a metallic layer, a glass substrate covered with a layer of a transparent conductive oxide (TCO), or a TCO-coated flexible transparent substrate.

Examples of the material for the metallic electrode are aluminum, silver, gold and/or molybdenum, wherein gold or molybdenum is preferably used.

Examples of the material for the transparent conductive oxide are indium-tin-oxide (ITO), fluorine-doped tin oxide (FTO) and aluminum-zinc-oxide, wherein ITO is preferably used.

The above materials are chosen based on e.g. their work-function, deposition method, temperature needed for the deposition, position in the electrode assembly, etc.

The first and second electrodes (1, 6) may be deposited, for example, by using an evaporation method, a sputter-coating method or atomic layer deposition (ALD).

Preferably, the particles (2) in said monolayer (b) are composed of silica, titania, alumina or mixtures thereof. Particles (2) composed of silica are preferred.

Preferably, the particles (2) in said monolayer (b) are spheres or ovoids. Particles (2) with the shape of sphere are preferred because it always offers a perpendicular surface to the tangent.

The particles (2) present in said monolayer (b) have an average particle size in a range of from 100 nm to 2 µm, preferably from 100 nm to 1 µm and more preferably from 200 nm to 800 nm.

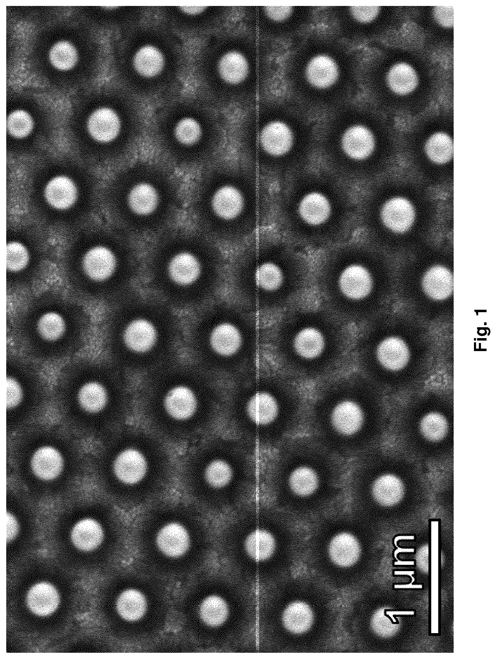

Preferably, said non-close packed monolayer of particles (2) is arranged in a hexagonal pattern. An example of a hexagonal pattern is shown in Fig. 1. Alternatively, said non-close packed monolayer of particles (2) is in a disordered arrangement (i.e. the particles are randomly distributed while their population density is kept similar as in the hexagonal pattern).

Preferably, said particles (2) building in the monolayer (b) are transparent, more preferably transparent for ultra-violet, visible and near-infrared wavelengths of the solar spectrum.

According to the present invention, said monolayer of particles (2) is a non-close packed monolayer, wherein the monolayer of particles (2) is obtained by depositing a non-close packed monolayer of core-shell particles and subsequently removing the shell from the as-deposited core-shell particles, leaving just the core of the particles, wherein a minimum interparticle distance in the monolayer of particles (2) is equal to or greater than two times the thickness of the shell of said core-shell particles.

The manufacturing of such a non-close packed monolayer of particles in a hexagonal pattern is disclosed in detail, for example, in J. S. J. Tang et al., ACS Omega 2018, 3, 12089-12098. Specifically, according to this document, poly(N-isopropylacrylamide)-silica (SiO₂@PnIPAm) core-shell particles are preassembled at an air/water interface via the Langmuir-Blodgett method, the interfacial spacer is transferred to a solid substrate, and the polymer shell is used as a sacrificial layer that can be thermally removed to leave a non-close packed silica monolayer. The shell thickness, crosslinking density, and the phase behavior upon compression of these complex particles at the air/water interface provide parameters to precisely control the lattice spacing in these surface nanostructures. By this method non-close packed arrays of silica spheres with interparticle distances between 400 and 1280 nm, up to 8 times their diameter, are achieved. Furthermore, the skilled person may transfer the method steps disclosed in this document to different materials for the core and shell materials without undue experimentation.

Apart of silica, the solid core of the core-shell particles can be made of other transparent materials, such as titania or alumina or mixtures of transparent materials.

Other types of polymers that can be etched or dissolved are also applicable as the shell material. For example, the polymeric shell can be composed of poly acrylic acid, poly allylamine, poly (diallyldimethylammonium chloride), poly (2-hydroxyethyl-methacrylat), poly (acrylamide), poly(N-isopropylacrylamide), poly(vinyalcohol). Poly(N-vinyl-pyrrolidone), poly(2-dimethylaminoethyl) methacrylate, gelatin and/or, alginate.

The same materials for the core and the shell can also be used when manufacturing of a non-close packed monolayer of particles in a disordered arrangement.

Furthermore, in order to provide a non-close packed monolayer of particles present in a disordered arrangement, for example, in the above-mentioned method the surface pressure upon compression of these complex particles at the air/water interface may be adjusted in a suitable manner, or core particles having different sizes may be mixed. Alternatively, a non-close packed monolayer of particles present in a disordered arrangement can be prepared via spin coating or drop casting.

Example materials for the electron transport material (ETM) layer (3) include TiO₂, ZnO, SnO₂ and/or CdS, preferably TiO₂ and/or ZnO.

The thickness of the electron transport material (ETM) layer (3) is between 10 and 200 nm, preferably between 30 and 80 nm.

Further preferred the electron transport material (ETM) layer (3) may comprise, preferably consist of, two layers. Each of these layers may include TiO₂, ZnO, SnO₂ and/or CdS. It is preferred that one layer includes TiO₂ and the other layer includes ZnO.

Preferably, an ultrathin interfacial layer is located between the electron transport material (ETM) layer (3) and the light-absorbing layer (4).

Example materials of the ultrathin interfacial layer include ZnS, ZnSe, SnS₂, SnSe₂, MoS₂, MoSe₂, Al₂O₃ or self-assembled monolayers, preferably ZnS.

Preferably, the thickness of the ultrathin interfacial layer is between 0.1 and 5 nm, preferably between 0.5 and 2 nm.

Example materials for the light-absorbing layer (4) include Sb₂S₃, Sb₂Se₃, a perovskite material, GaAs, CdTe, CZTS-based (copper zinc tin sulfide, selenide) material, CIGS-based (copper indium gallium sulfide, selenide) material and/or mixtures thereof, preferably Sb₂S₃, Sb₂Se₃, a perovskite material, and/or mixtures thereof.

The thickness of the light-absorbing layer is 2 µm or less, preferably 1 µm or less and more preferably of 100 nm or less. The thickness of the light-absorbing layer is more than 5 nm, and preferably more than 15 nm.

Example materials for the hole transport material (HTM) layer (5) include P3HT (poly-3-hexylthiophene), PCPDTBT (poly[2,6-(4,4-bis-(2-ethylhexyl)-4H-cyclopenta-[2,1-b;3,4-b']dithiophene)-alt-4,7(2,1,3-benzothiadiazole)], PTAA (poyl(triarylamine)), Spiro-OMeTAD, Poly(3,4-ethylenedioxythio-phene) polystyrene sulfonate (PEDOT:PSS), MoO₃, MoS₂, MoSe₂, V₂O₅, and NiO.

The thickness of the hole transport material (HTM) layer (5) is between 10 and 200 nm, preferably between 20 and 70 nm.

Further preferred the hole transport material (HTM) layer (5) may comprise, preferably consist of, two layers. Each of these layers may include P3HT (poly-3-hexylthiophene), PCPDTBT (poly[2,6-(4,4-bis-(2-ethylhexyl)-4H-cyclopenta-[2,1-b;3,4-b]dithiophene)-alt-4,7(2,1,3-benzothiadiazole)], PTAA (poyl(triarylamine)), Spiro-OMeTAD, Poly(3,4-ethylenedioxythio-phene) polystyrene sulfonate (PEDOT:PSS), MoO₃, MoS₂, MoSe₂, V₂O₅, and NiO. It is preferred that one layer includes P3HT (poly-3-hexylthiophene) and the other layer includes Poly(3,4-ethylenedioxythio-phene) polystyrene sulfonate (PEDOT:PSS).

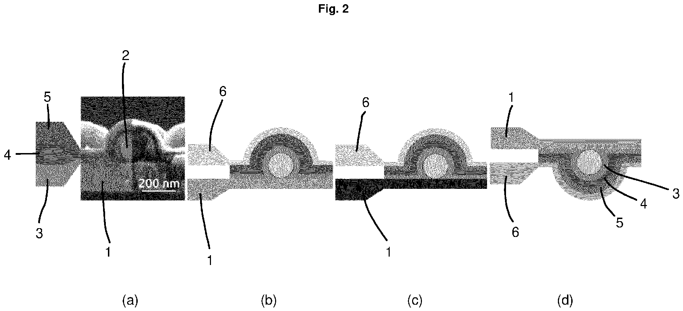

In the following, three possible layer structures for the electrode assembly of the present invention are described with reference to Fig. 2(a) to (d), wherein Fig. 2(a) shows the sub-layer structure of the electron transport material (ETM) layer (3), the light-absorbing layer (4), and the hole transport material (HTM) (5), which together form a "heterojunction".

Fig. 2(a) shows an enlarged cross-section through an electrode assembly composed of a first electrode (1), a particle (2) present on the first electrode (1), an ETM layer (3) covering part of the first electrode (1) and the whole particle (2), a light-absorbing layer (4) covering the ETM layer (3), and a HTM layer (5) covering the light-absorbing layer (4).

One possible layer structure for the electrode assembly of the present invention shown in Fig. 2(b) is a semitransparent configuration. The semitransparent configuration is such that both the first and second electrodes (1) and (6) are a TCO-coated glass substrate.

An alternative shown in Fig. 2(c) is a configuration having a planar rear reflector electrode (1). This configuration is such that a TCO-coated glass substrate is used as the second (front) electrode (6) and a metal is used as the first electrode (1) (planar rear reflector electrode).

A further alternative shown in Fig. 2(d) is a configuration having a profiled rear reflector electrode (1). This configuration is such that a TCO-coated glass substrate is used as the first (front) electrode (1) and a metal is used as the second electrode (6) (profiled rear reflector electrode).

The configuration of the electrode assemblies according to Fig. 2 (b), (c), and (d) depends on the use case. It is also possible to inverse the order of the layers forming the heterojunction for each type of electrode (e.g. in Fig. 2(c): Metallic electrode (1), HTM layer (5), light-absorbing layer (4), ETM layer (3), TCO (6)).

The above-mentioned electrode materials are merely examples and the same are chosen considering their work function and the position of the conduction and valence band of the ETM and HTM, respectively. Examples of materials combinations for stacks of layers forming a solar cell are e.g. ITO (electrode (1)) / ZnO (ETM layer (3)) / TiO₂ (ETM layer (3)) / Sb₂S₃ (light absorbing layer (4)) / V₂O₅ (HTM layer (5)) /Au (electrode (1)); or Mo (electrode (1)) / MoS₂ (HTM layer (5)) / CIGS (light absorbing layer (4)) / CdS (ETM layer (3)) / ZnO (ETM layer (3)) / ITO (electrode (6)); or ITO (electrode (1)) / TiO₂ (ETM layer (3)) / Sb₂Se₃ (light absorbing layer (4)) / MoO₃ (HTM layer (5)) / ITO (electrode (6)).

Examples of materials combinations for stack of layers including a monolayer of particles: ITO (electrode (1)) / SiO₂ spheres (monolayer of particles layer (2)) / ZnO (ETM layer (3)) / TiO₂ (ETM layer (3)) / Sb₂S₃ (light absorbing layer (4)) / V₂O₅ (HTM layer (5)) / Au (electrode (1)); or Mo (electrode (1)) / MoS₂ (HTM layer 5) / SiO₂ spheres (monolayer of particles layer (2)) / CIGS (light absorbing layer (4)) / CdS (ETM layer (3)) / ZnO (ETM layer (3)) /ITO (electrode (6)); or ITO (electrode (1)) / SiO₂ spheres (monolayer of particles layer (2)) / TiO₂ (ETM layer (3)) / Sb₂Se₃ (light absorbing layer (4)) / MoO₃ (HTM layer (5)) / ITO (electrode (6))

Another aspect of the present invention relates to a process for manufacturing an electrode assembly according to the claims comprising, preferably consisting of,
a) providing a first electrode (1),
b) depositing a monolayer of particles (2) on a surface of said first electrode (1),
c) depositing an electron transport material (ETM) layer (3), a light absorbing layer (4), a hole transport material (HTM) layer (5) and a second electrode (6) on top of said monolayer of particles (2),

wherein at least one of the first and the second electrode (1, 6) is transparent, and wherein said monolayer of particles (2) is a non-close packed monolayer,
wherein the particles (2) are not in contact with each other, and wherein
   the electron transport material (ETM) layer (3) has a thickness between 10 and 200 nm,
   the light-absorbing layer (4) has a thickness of 2 µm or less, and
   the hole transport material (HTM) layer (5) has a thickness between 10 and 200 nm.

All remarks with respect to the first electrode (1), the monolayer of particles (2) and its manufacturing, the electron transport material (ETM) layer (3), the light-absorbing layer (4), the hole transport material (HTM) layer (5), and the second electrode (6) as mentioned hereinbefore also apply to the process for manufacturing an electrode assembly where applicable.

Preferably, said monolayer of particles (2) is deposited on said first electrode (1) via the Langmuir-Blodgett method.

Preferably, the interparticle distance and the arrangement of said particles (2) in said monolayer is controlled via variation of the surface pressure in the Langmuir-Blodgett trough. By varying the surface pressure hexagonally oriented arrays or disordered arrays can be obtained.

Preferably, step b) comprises depositing a non-close packed monolayer of core-shell particles on the first electrode (1) and subsequently removing the polymeric shell from said as-deposited core-shell particle monolayer prior to step c) and wherein a minimum interparticle distance in the monolayer of particles (2) obtained in step b) is equal to or greater than two times the thickness of the shell of said core-shell particles. This step is valid for generating both hexagonal and disordered patterns using the Langmuir-Blodgett trough as described above.

In contrast to the hexagonal pattern, in an alternative embodiment, in step b) the monolayer of particles (2) comprises at least two distinct types of particles (2) which differ in their average particle diameter, for example 200 and 800 nm, resulting in a random particle order, i.e. a disordered array. Another way to create disordered arrays of particles is by adjusting the surface pressure in the Langmuir-Blodgett trough in the required surface pressure range.

Preferably, in step c) the ETM layer(s) (3) is/are deposited on said non-close packed monolayer of particles (2), for example, via atomic layer deposition (ALD) and/or sputter coating.

Preferably, in step c) the light absorbing layer (4) is deposited on said ETM layer(s) (3), for example, via ALD, evaporation or spin coating.

Preferably, in step c) the HTM layer(s) (5) is/are deposited on said light absorbing layer (4), for example, via ALD, spin coating or sputter coating.

More preferably, in step c), the ETM layer(s) (3) and/or the light absorbing layer (4) is/are deposited on said non-close packed monolayer of particles (2) via ALD.

The thickness of the light absorbing layer (4) is 2 µm or less, preferably 1 µm or less, more preferably 100 nm or less.

Preferably, the particles (2) deposited on said first electrode (1) and/or said solid core of the core-shell particles are made of a transparent material, preferably made of silica, titania, alumina or mixtures thereof.

Another aspect of the present invention relates to a photovoltaic device, preferably a thin-film photovoltaic device, comprising an above-mentioned electrode assembly according to the claims.

Another aspect of the present invention relates to the use of a non-close packed monolayer of transparent particles in an above-mentioned electrode assembly according to the claims.

### EXAMPLE SECTION

In the following, a practical example for manufacturing and characterizing the electrode assembly of the present invention is provided, wherein each step of the process for manufacturing an electrode assembly of the present invention is explained in detail in a non-restrictive and exemplary manner.

### Preparation of Inventive electrode assembly (Inventive Example, IE)

### 1. Providing a first electrode

Tin-doped indium oxide (ITO) coated glass slides with 10 Ω/sq are purchased from Solaronix and used as the first electrode.

### 2. Depositing a monolayer of particles on a surface of said first electrode

All the chemicals were purchased from commercial sources and used as received unless stated otherwise. N,N'-Methylenebis(acrylamide) (BIS; 99 %, Sigma-Aldrich), ammonium persulfate (APS, Sigma-Aldrich, 98 %), ethanol (EtOH, Sigma-Aldrich, 99.9 %), hexane (≥99 %, Sigma-Aldrich), tetraethyl orthosilicate (TEOS; 98 %, Sigma-Aldrich), ammonium hydroxide solution (28-30 % NH₃ basis, Sigma-Aldrich), (3-(trimethoxysilyl)propyl methacrylate) (MPS; 98 %, Sigma-Aldrich), fluorescein isothiocyanate isomer I (FITC; Sigma-Aldrich, >90 %), (3-aminopropyl)triethoxysilane (APTS; Sigma-Aldrich, >98 %), hydrofluoric acid (HF, AnalaR NORMAPUR, VWR, 40 %), and hydrogen peroxide (H₂O₂, EMSURE, Merck, 30 %) were used as received. N-Isopropylacrylamide (NiPAm; 97 %, Sigma-Aldrich) was purified by recrystallization from hexane (95 %, Sigma-Aldrich). Water was double deionized using a Milli-Q system (18.2 MΩ cm, Elga PURELAB Flex).

Fluorescent silica nanoparticles with a diameter of 160 nm (±10 nm) were prepared according to the Stoeber process. First, 5.8 mg FITC (1.5 × 10⁻² mmol) was dissolved in 1.5 mL EtOH (10 mM). Then, 26.19 µL APTS (1.5 × 10⁻¹ mmol, 10 equiv) was added to the solution. After the mixture was stirred for 2.5 h in the dark, 900 µL of the reaction mixture was diluted with 4.50 mL of EtOH (5 vol. equiv).

In a **round-bottom** flask, 250 mL EtOH, 12.5 mL Milli-Q water and 25 mL NH₃ (aq) were stirred together. TEOS, 18.75 mL, was stirred in 75 mL EtOH and both solutions were heated to 50 °C and equilibrated for 30 min. The TEOS solution was then quickly added to the first mixture under heavy stirring. As soon as the reaction mixture became turbid, the prepared fluorescent dye solution was slowly added within 8 min. The reaction is allowed to proceed for 2 days at 50 °C.

This suspension was used for functionalization without any further purification. The fluorescent silica nanoparticles were functionalized with MPS and its amount was calculated to obtain one molecule of MPS per 40 Å² surface area. The surface area of the silica particles was approximately calculated by determining the mass fraction of the silica dispersion and using a density of 2.0 g/cm³, not taking the porosity of Stoeber particles into account. MPS, 102.7 µL (3.9 × 10⁻⁴ mmol), was rapidly added to the silica dispersion. The reaction mixture was stirred at room temperature for at least 1 day and then boiled for 1 hour to ensure successful functionalization. Afterwards, the particles were purified by centrifugation and then redispersed three times in ethanol and three times in Milli-Q water. A yellow silica dispersion of 6.59 wt.% was obtained.

A PNiPAm-microgel shell was polymerized on the silica nanoparticles synthesized in the above-described manner via surfactant-free precipitation polymerization. In particular, in a round-bottom flask, 282.9 mg of NiPAm (2.5 mmol; 50 mmol/L) and the respective amount of BIS were dissolved in Milli-Q water. Then the prepared silica dispersion was slowly added under stirring. The mixture was heated to 80 °C and purged with nitrogen. After an equilibration time of 30 min, the nitrogen gas inlet was replaced by a nitrogen-filled balloon to sustain the nitrogen atmosphere. The reaction was started by rapidly adding 114 mg of APS dissolved in 1 mL Milli-Q water. The reaction was carried out for an hour before quickly adding 114 mg of APS dissolved in 1 mL Milli-Q water again. Subsequently, a nitrogen-purged solution of NiPAm and BIS was added using a syringe pump (3 mL/h; 6 mmol/L) for further shell growth. Two hours after the last addition of the reagents, the reaction mixture was allowed to cool to room temperature. The core-shell particles were purified by centrifugation with Milli-Q water to remove microgel particles and pure silica nanoparticles.

A Teflon Langmuir trough (Kibron, Microtrough G2, area = 324 cm²) equipped with two Teflon barriers is used to prepare the monolayers of silica-PNIPAM core-shell spheres. A Wilhelmy plate is used to measure the surface pressure during the simultaneous compression and deposition process. An above-mentioned ITO coated glass slide with dimensions of 2.0 x 2.5 cm² is cleaned by sonication in a detergent (Hellmanex III, 2 %), acetone, isopropanol and DI water, respectively, for 5 min each. The glass slide is exposed to oxygen plasma (Diener) for 5 min right before the deposition of the silica-PNIPAm core-shell spheres. The core-shell colloidal dispersion is diluted 1: 1 with ethanol as the spreading agent. The core-shell spheres are spread at the water-air interface on the Langmuir through until the surface is completely covered as evidenced by the onset of a rise in surface pressure. The interface is compressed by the barriers until a surface pressure of 32 mN/m is reached. The ITO coated glass slide is lifted at a speed of 10 mm/min. Last, the organic microgel shell is removed using oxygen plasma, resulting in a non-close packed hexagonal arrangement of silica spheres on the glass slides.

### 3. Depositing an ETM layer on the ITO coated glass slides provided with the non-close packed hexagonal arrangement of silica spheres

A compact layer of ZnO with a thickness of 40 nm is grown in a hot-wall ALD reactor (Gemstar-6 XI, Arradiance) with diethylzinc (DEZ, 95 %, abcr) and millipore water as precursors and nitrogen as carrier gas. Both precursors are kept at room temperature and the reaction chamber is heated to 120 °C. The pulse times are 0.15 s for DEZ and 0.3 s for water with exposure and pumping times of 30 and 60 s, respectively.

45 nm of TiO₂ are deposited as ETM by radio frequency magnetron sputtering (CRC 622 model, Torr International, Inc.) from a TiO₂ target (99.99 %). The working pressure, base pressure and power density are 0.3 Pa, 1 x 10⁻⁴ Pa and 2.5 W cm⁻², respectively, resulting in a deposition rate of 0.1 Å/s. The working gas is argon (99. 999 %) at a flow rate of 5 sccm. The as-grown amorphous TiO₂ films are crystallized to anatase phase by annealing on a hotplate at 500 °C for 30 min in ambient atmosphere.

### 4. Depositing a light absorbing layer on the ETM layer

Atomic layer deposition of ZnS, Sb₂S₃ (light absorbing material) and ZnO capping layers are performed on UV/ ozone cleaned substrates (30 min) in a customized hot-wall ALD reactor. The precursors are diethylzinc (DEZ, 95 %, abcr), tris(dimethylamido)antimony (TDMASb, 99.99 %, Sigma Aldrich), H₂S (3 % in N₂, Air Liquide) and milli-pore water. All precursors are kept at room temperature, except for TDMASb, which is heated to 40 °C to create sufficient vapor pressure. 9 cycles of ZnS (1 nm) are deposited by ALD at 150 °C with pulse, exposure and pumping times of 0.2 s, 30 s and 40 s for both DEZ and H₂. Thereafter the chamber is cooled to 120 °C for Sb₂S₃ deposition (600 cycles, 35 nm) without breaking vacuum. The exposure and pumping times were 15 s each, with pulse times of 1.5 s and 0.2 s for TDMASb and H₂S, respectively. The ALD is cooled to room temperature before opening. Sample is exposed to UV/ozone (Novascan PSD-UV4) that is operated using oxygen from ambient air for 1 min. Deposition of the ZnO capping layer ALD is performed at 120 °C for 200 cycles (20 nm), with a pulse, exposure and pump duration of 0.2 s, 15 s and 15 s, respectively. After ZnO deposition, the ALD reactor is cooled to room temperature before opening. The as-grown amorphous Sb₂S₃ layers are converted to stibnite phase by annealing on a hotplate in an N₂-filled glovebox at 300 °C for 2 min. The ZnO capping layer is removed after annealing by etching in 5 % acetic acid solution for 2 min. The sample is then rinsed with 3 % acetic acid and DI water and blown dry with nitrogen.

### 5. Depositing a HTM layer on the light absorbing layer

A hole selective layer of poly-3-hexylthiophene (P3HT, regioregular, Sigma Aldrich, 15 mg/mL in chlorobenzene) is deposited on the light absorbing layer by dynamic spin coating 50 µL at 6000 rpm for 1 min in ambient atmosphere and then dried on a hotplate in an N₂-filled glovebox at 90 °C for 30 min. Poly(3,4-ethylenedioxythio-phene) polystyrene sulfonate (PEDOT:PSS, HTL Solar, Ossila) is spin coated at 6000 rpm for 1 min with an acceleration of 6000 rpm/s and again dried at 90 °C for 30 min in an N₂-filled glovebox.

### 6. Depositing a second electrode on the HTM layer

80 nm of gold are deposited on the HTM layer by thermal evaporation through a shadow mask with an active device area of 0.075 cm².

### Preparation of Comparative electrode assembly (Comparative Example, CE)

The comparative electrode assembly was prepared according to the procedure applied for the preparation of the Inventive electrode assembly with the difference that step 2. *(depositing a monolayer of particles on a surface* of *said first electrode)* has been omitted. By that a planar electrode assembly was obtained.

### Characterization of the performance of a solar cell including the manufactured electrode assembly (Inventive Example, IE) in comparison with a solar cell including a conventional electrode assembly lacking the monolayer of particles (Comparative Example, IE)

Solar cell performance was measured under ambient conditions using a solar simulator (Newport, Xe lamp source) that was calibrated to AM1.5 at 100 mW cm⁻² with a reference Si solar cell (Newport). A single-channel Gamry Reference 600 was used to record JV-curves with a scan speed of 50 mV/s from -0.3 to 1 V unless stated otherwise. An Oriel's QEPVSI-b system with a 300 W Xe light source, a monochromator and a lock-in amplifier was used to record EQE spectra. The thicknesses of the different layers deposited by ALD and sputtering were measured by spectroscopic ellipsometry (SENpro, Sentech).

Fig. 3(a) shows the photocurrent density (J), in the Y axes, versus voltage (V), in the X axes, of the two representative solar cell devices according to the structured electrode (Inventive Example, IE) and the planar configuration (i.e. non-structured, Comparative Example, CE) having the same heterojunction materials and thicknesses under light illumination at 100 mW cm⁻². The solid line represents a solar cell in structured electrode configuration (IE), while the dashed line represents a solar cell in a planar configuration (CE) as described above. The photovoltaic parameters extracted from the current density - voltage curves of several devices, which are fabricated out of the same original sample, are presented in Fig. 3 (b,c,d,e) and the values in Table 1.

**Table 1: Median values of the measured values of Jsc, Voc, FF and Efficiency of the devices.**

| Median values | | | | | | | |
|---|---|---|---|---|---|---|---|
| Jsc / mA·cm⁻² | | Voc / mV | | FF | | Efficiency / % | |
| CE | IE | CE | IE | CE | IE | CE | IE |
| 10.21 | 12.81 | 709 | 698 | 44.51 | 45.34 | 3.29 | 4.34 |

The performance of the samples is evaluated on basis of the photocurrent calculated from the integration of the external quantum efficiency (EQE) spectra at different angles from 0° to 60°. Fig. 4(a) shows the EQE spectra (Y left axis) and the corresponding integrated Jsc curve (Y right axis) in function of the incident light wavelength. Fig. 4(a) demonstrates that IE solar cells generate more photocurrent over the whole spectrum and that at longer wavelengths this difference is more significant. Fig. 4(b) represents the ratio between EQE spectra from IE and CE (Y axis) in function of the incident light wavelength. Fig. 4(b) confirms that the enhancement of light absorption with respect to the CE samples improves at higher angles, in particular this difference is larger at longer wavelengths.

Fig. 5(a) displays the short circuit current Jsc (Y axis), calculated by integrating the measured EQE spectra, versus the incidence angle of light (X axis). Fig. 5(a) demonstrates that the inventive electrode IE assembly generates higher photocurrent not only at normal incidence, but also at every angle in comparison to the comparative electrode CE assembly. The corresponding values are displayed in Table 2.

**Table 2: Incidence angle and respective values of the integrated Jsc calculated from EQE.**

| Incidence angle / ° | Integrated Jsc / mA·cm⁻² | |
|---|---|---|
| | CE | IE |
| 0 | 11.1 | 13.23 |
| 10 | 11.24 | 12.91 |
| 20 | 10.38 | 12.58 |
| 30 | 10.19 | 11.91 |
| 40 | 8.8 | 10.76 |
| 50 | 7.58 | 9.15 |
| 60 | 5.61 | 7.39 |

Fig. 5(b) displays the short-circuit current taking into account the diminishing effective photon density incident onto the electrode as a result of the tilting (Y axis) versus the incidence angle of light (X axis). The corresponding correction applies considering the projection of the total area of the electrode as the inverse of the cosine of the incident angle or tilting. Fig. 5(b) shows that the real EQE of the structured solar cell device (IE), and therefore the generated photocurrent, at higher angles increases in comparison to the planar solar cell device (CE). The corresponding values are displayed in Table 3.

**Table 3: Incidence angle and respective the values of the integrated Jsc corrected photon density calculated from EQE.**

| Incidence angle / ° | Integrated Jsc / mA·cm⁻² | Integrated Jsc photon density corrected / mA·cm⁻² |
|---|---|---|
| | CE | IE |
| 0 | 11.1 | 13.23 |
| 10 | 11.41 | 13.11 |
| 20 | 11.05 | 13.39 |
| 30 | 11.77 | 13.76 |
| 40 | 11.49 | 14.04 |
| 50 | 11.79 | 14.24 |
| 60 | 11.22 | 14.78 |

## Claims

1. Electrode assembly comprising
(a) a first electrode (1),
(b) a monolayer of particles (2),
(c) an electron transport material (ETM) layer (3) having a thickness between 10 and 200 nm,
(d) a light-absorbing layer (4) having a thickness of 2 µm or less,
(e) a hole transport material (HTM) layer (5) having a thickness between 10 and 200 nm, and
(f) a second electrode (6),
wherein at least one of the first and the second electrode (1, 6) is transparent;
wherein said monolayer of particles (2) is a non-close packed monolayer;
wherein the monolayer of particles (2) is obtained by depositing a non-close packed monolayer of core-shell particles and subsequently removing the shell from said as-deposited non-close packed monolayer of core-shell particles such that the resulting particles (2) are not in contact with each other; and
wherein a minimum interparticle distance in the monolayer of particles (2) is equal to or greater than two times the thickness of the shell of said core-shell particles, and
wherein the particles (2) comprised in said monolayer (b) have an average particle size in a range of from 100 nm to 2 µm, preferably from 100 nm to 1 µm and more preferably from 200 nm to 800 nm.

2. Electrode assembly according to claim 1, wherein said non-close packed monolayer of particles (2) is arranged in a hexagonal pattern.

3. Electrode assembly according to anyone of the preceding claims, wherein said particles (2) comprised in the monolayer of particles (2) are transparent, preferably said particles (2) are comprised of silica, titania, alumina or mixtures thereof.

4. Process for manufacturing an electrode assembly according to claims 1 to 3 comprising
a) providing a first electrode (1),
b) depositing a monolayer of particles (2) on a surface of said first electrode (1),
c) depositing an electron transport material (ETM) layer (3), a light absorbing layer (4), a hole transport material (HTM) layer (5) and a second electrode (6) on top of said monolayer of particles (2),
wherein at least one of the first and the second electrode (1, 6) is transparent, and wherein said monolayer of particles (2) is a non-close packed monolayer,
wherein the particles (2) are not in contact with each other, and wherein
the electron transport material (ETM) layer (3) has a thickness between 10 and 200 nm,
the light-absorbing layer (4) has a thickness of 2 µm or less, and
the hole transport material (HTM) layer (5) has a thickness between 10 and 200 nm.

5. Process according to claim 4 wherein said monolayer of particles (2) is deposited on said first electrode (1) via the Langmuir-Blodgett method.

6. Process according to claim 5 wherein the interparticle distance of the particles (2) in said monolayer (b) is controlled via variation of the surface pressure in the Langmuir-Blodgett trough.

7. Process according to anyone of claims 4 to 6, wherein step b) comprises depositing a non-close packed monolayer of core-shell particles on the first electrode (1) and subsequently removing the polymeric shell from said as-deposited core-shell particle monolayer prior to step c) and wherein a minimum interparticle distance in the monolayer of particles (2) obtained in step b) is equal to or greater than two times the thickness of the shell of said core-shell particles.

8. Process according to anyone of claims 4 to 7, wherein in step b) the monolayer of particles (2) comprises at least two distinct types of particles (2) which differ in their average particle diameter.

9. Process according to anyone of claims 4 to 8, wherein in step c), the ETM layer (3) and/or the light absorbing layer (4) is/ are deposited on said non-close packed monolayer of particles (2) via atomic layer deposition (ALD).

10. Process according to anyone of claims 4 to 9, wherein the particles (2) deposited on said first electrode (1) and/or said solid core of the core-shell particles are made of a transparent material, preferably made of silica, titania, alumina or mixtures thereof.

11. Photovoltaic device, preferably thin-film photovoltaic device, comprising an electrode assembly according to anyone of claims 1 to 3 or obtained by a process according to anyone of claims 4 to 10.

12. Use of a non-close packed monolayer of transparent particles to optimize light harvesting as well as charge generation and extraction of an electrode assembly according to claims 1 to 3.

## Patentansprüche

1. Elektrodenanordnung, umfassend
(a) eine erste Elektrode (1),
(b) eine Monoschicht aus Teilchen (2),
(c) eine Schicht (3) aus einem Elektronentransportmaterial (Electron Transport Material, ETM) mit einer Dicke zwischen 10 und 200 nm,
(d) eine lichtabsorbierende Schicht (4) mit einer Dicke von 2 µm oder weniger,
(e) eine Schicht (5) aus einem Lochtransportmaterial (Hole Transport Material, HTM) mit einer Dicke zwischen 10 und 200 nm und
(f) eine zweite Elektrode (6),
wobei mindestens eine der ersten und zweiten Elektroden (1, 6) transparent ist;
wobei die Monoschicht aus Teilchen (2) eine nicht dicht gepackte Monoschicht ist;
wobei die Monoschicht aus Teilchen (2) durch Abscheiden einer nicht dicht gepackten Monoschicht aus Kern-Schale-Teilchen und anschließendes Entfernen der Schale von der so abgeschiedenen nicht dicht gepackten Monoschicht aus Kern-Schale-Teilchen derart erlangt wird, dass die resultierenden Teilchen (2) nicht miteinander in Kontakt stehen; und
wobei ein minimaler Abstand zwischen den Teilchen in der Monoschicht aus Teilchen (2) gleich oder größer als das Zweifache der Dicke der Schale der Kern-Schale-Teilchen ist, und wobei die in der Monoschicht (b) umfassenden Teilchen (2) eine durchschnittliche Teilchengröße im Bereich von 100 nm bis 2 µm, vorzugsweise von 100 nm bis 1 µm und insbesondere vorzugsweise von 200 nm bis 800 nm aufweisen.

2. Elektrodenanordnung nach Anspruch 1, wobei die nicht dicht gepackte Monoschicht aus Teilchen (2) in einem hexagonalen Muster angeordnet ist.

3. Elektrodenanordnung nach einem der vorhergehenden Ansprüche, wobei die in der Monoschicht aus Teilchen (2) umfassten Teilchen (2) transparent sind, vorzugsweise umfassen die Teilchen (2) Siliziumdioxid, Titandioxid, Aluminiumoxid oder Mischungen davon.

4. Verfahren zur Herstellung einer Elektrodenanordnung nach Anspruch 1 bis 3, umfassend
a) das Bereitstellen einer ersten Elektrode (1),
b) Abscheiden einer Monoschicht aus Teilchen (2) auf einer Oberfläche der ersten Elektrode (1),
c) Abscheiden einer Schicht (3) aus einem Elektronentransportmaterial (ETM), einer lichtabsorbierenden Schicht (4), einer Schicht (5) aus einem Lochtransportmaterial (HTM) und einer zweiten Elektrode (6) auf der Monoschicht aus Teilchen (2),
wobei mindestens eine der ersten und zweiten Elektroden (1, 6) transparent ist und wobei die Monoschicht aus Teilchen (2) eine nicht dicht gepackte Monoschicht ist,
wobei die Teilchen (2) nicht miteinander in Kontakt stehen und wobei
die Schicht (3) aus Elektronentransportmaterial (ETM) eine Dicke zwischen 10 und 200 nm aufweist,
die lichtabsorbierende Schicht (4) eine Dicke von 2 µm oder weniger aufweist, und
die Schicht (5) aus dem Lochtransportmaterial (HTM) eine Dicke zwischen 10 und 200 nm aufweist.

5. Verfahren nach Anspruch 4, wobei die Monoschicht aus Teilchen (2) über das Langmuir-Blodgett-Verfahren auf der ersten Elektrode (1) abgeschieden wird.

6. Verfahren nach Anspruch 5, wobei der Abstand zwischen den Teilchen (2) in der Monoschicht (b) über die Variation des Oberflächendrucks in der Langmuir-Blodgett-Rinne gesteuert wird.

7. Verfahren nach einem der Ansprüche 4 bis 6, wobei Schritt b) das Abscheiden einer nicht dicht gepackten Monoschicht aus Kern-Schale-Teilchen auf der ersten Elektrode (1) und anschließendes Entfernen der polymeren Schale von der abgeschiedenen Monoschicht aus Kern-Schale-Teilchen vor Schritt c) umfasst und wobei ein minimaler Abstand zwischen den Teilchen in der in Schritt b) erlangten Monoschicht aus Teilchen (2) gleich oder größer als das Zweifache der Dicke der Schale der Kern-Schale-Teilchen ist.

8. Verfahren nach einem der Ansprüche 4 bis 7, wobei in Schritt b) die Monoschicht aus Teilchen (2) mindestens zwei verschiedene Arten von Teilchen (2) umfasst, die sich in ihrem durchschnittlichen Teilchendurchmesser unterscheiden.

9. Verfahren nach einem der Ansprüche 4 bis 8, wobei in Schritt c) die ETM-Schicht (3) und/oder die lichtabsorbierende Schicht (4) auf der nicht dicht gepackten Monoschicht aus Teilchen (2) über Atomlagenabscheidung (Atomic Layer Deposition, ALD) abgeschieden wird/werden.

10. Verfahren nach einem der Ansprüche 4 bis 9, wobei die auf der ersten Elektrode (1) und/oder dem festen Kern der Kern-Schale-Teilchen abgeschiedenen Teilchen (2) aus einem transparenten Material hergestellt sind, vorzugsweise aus Siliziumdioxid, Titandioxid, Aluminiumoxid oder Mischungen davon.

11. Photovoltaische Vorrichtung, vorzugsweise eine photovoltaische Dünnschichtvorrichtung, umfassend eine Elektrodenanordnung nach einem der Ansprüche 1 bis 3 oder erlangt durch ein Verfahren nach einem der Ansprüche 4 bis 10.

12. Verwendung einer nicht dicht gepackten Monoschicht aus durchsichtigen Teilchen zur Optimierung der Lichtsammlung sowie der Ladungserzeugung und -extraktion einer Elektrodenanordnung nach einem der Ansprüche 1 bis 3.

## Revendications

1. Ensemble d'électrodes comprenant
(a) une première électrode (1),
(b) une monocouche de particules (2),
(c) une couche de matériau de transport d'électrons (ETM) (3) ayant une épaisseur comprise entre 10 et 200 nm,
(d) une couche absorbant la lumière (4) ayant une épaisseur de 2 µm ou moins,
(e) une couche de matériau de transport de trou (HTM) (5) ayant une épaisseur comprise entre 10 et 200 nm, et
(f) une seconde électrode (6),
dans lequel au moins l'une des première et seconde électrodes (1, 6) est transparente ;
dans laquelle ladite monocouche de particules (2) est une monocouche non compacte ;
dans laquelle la monocouche de particules (2) est obtenue en déposant une monocouche non compacte de particules à noyau-enveloppe puis en retirant l'enveloppe de ladite monocouche non compacte de particules à noyau-enveloppe déposée de telle sorte que les particules résultantes (2) ne soient pas en contact les unes avec les autres ; et
dans laquelle une distance interparticulaire minimale dans la monocouche de particules (2) est égale ou supérieure à deux fois l'épaisseur de l'enveloppe desdites particules à noyau-enveloppe, et
dans laquelle les particules (2) comprises dans ladite monocouche (b) ont une taille de particule moyenne comprise dans une plage de 100 nm à 2 µm, de préférence de 100 nm à 1 µm et de manière particulièrement préférée de 200 nm à 800 **nm.**

2. Ensemble d'électrodes selon la revendication 1, dans lequel ladite monocouche non compacte de particules (2) est disposée selon un motif hexagonal.

3. Ensemble d'électrodes selon l'une quelconque des revendications précédentes, dans lequel lesdites particules (2) comprises dans la monocouche de particules (2) sont transparentes, de préférence lesdites particules (2) sont constituées de silice, de titane, d'alumine ou de mélanges de ceux-ci.

4. Procédé de fabrication d'un ensemble d'électrodes selon les revendications 1 à 3 comprenant
a) la fourniture d'une première électrode (1),
b) le dépôt d'une monocouche de particules (2) sur une surface de ladite première électrode (1),
c) le dépôt d'une couche de matériau de transport d'électrons (ETM) (3), d'une couche absorbant la lumière (4), d'une couche de matériau de transport de trous (HTM) (5) et une seconde électrode (6) au-dessus de ladite monocouche de particules (2),
dans lequel au moins l'une des première et seconde électrodes (1, 6) est transparente, et dans lequel ladite monocouche de particules (2) est une monocouche non compacte,
dans lequel les particules (2) ne sont pas en contact les unes avec les autres, et dans lequel
la couche de matériau de transport d'électrons (ETM) (3) possède une épaisseur comprise entre 10 et 200 nm,
la couche absorbant la lumière (4) possède une épaisseur de 2 µm ou moins, et
la couche de matériau de transport de trous (HTM) (5) possède une épaisseur comprise entre 10 et 200.

5. Procédé selon la revendication 4 dans lequel ladite monocouche de particules (2) est déposée sur ladite première électrode (1) par la méthode de Langmuir-Blodgett.

6. Procédé selon la revendication 5 dans lequel la distance interparticulaire des particules (2) dans ladite monocouche (b) est contrôlée par variation de la pression de surface dans la cuve de Langmuir-Blodgett.

7. Procédé selon l'une quelconque des revendications 4 à 6, dans lequel l'étape b) comprend le dépôt d'une monocouche non compacte de particules à noyau-enveloppe sur la première électrode (1) et le retrait consécutif de l'enveloppe polymère de ladite monocouche de particules à noyau-enveloppe telle que déposée avant l'étape c) et dans lequel une distance interparticulaire minimale dans la monocouche de particules (2) obtenue à l'étape b) est égale ou supérieure à deux fois l'épaisseur de l'enveloppe desdites particules à noyau-enveloppe.

8. Procédé selon l'une quelconque des revendications 4 à 7, dans lequel à l'étape b) la monocouche de particules (2) comprend au moins deux types distincts de particules (2) qui diffèrent par leur diamètre de particule moyen.

9. Procédé selon l'une quelconque des revendications 4 à 8, dans lequel, à l'étape c), la couche ETM (3) et/ou la couche absorbant la lumière (4) est/sont déposée(s) sur ladite monocouche non compacte de particules (2) via dépôt par couches atomiques (ALD) .

10. Procédé selon l'une quelconque des revendications 4 à 9, dans lequel les particules (2) déposées sur ladite première électrode (1) et/ou ledit noyau solide des particules à noyau-enveloppe sont constituées d'un matériau transparent, de préférence constitué de silice, d'oxyde de titane, d'alumine ou de mélanges de ceux-ci.

11. Dispositif photovoltaïque, de préférence dispositif photovoltaïque à couche mince, comprenant un ensemble d'électrodes selon l'une quelconque des revendications 1 à 3 ou obtenu par un procédé selon l'une quelconque des revendications 4 à 10.

12. Utilisation d'une monocouche non compacte de particules transparentes pour optimiser la collecte de lumière ainsi que la génération et l'extraction de charge d'un ensemble d'électrodes selon les revendications 1 à 3.
